# EUROPEAN PATENT APPLICATION

(11) **EP 4 607 801 A1**
(43) Date of publication of application: **27.08.2025**
(21) Application number: 25151464.2
(22) Date of filing: 13.01.2025
(51) Int. Cl.: H03K 19/17752, H03K 19/17756, G06F 30/33, G06F 30/34

(54) **TECHNIQUES FOR COARSE GRAINED AND FINE GRAINED CONFIGURATIONS OF CONFIGURABLE LOGIC CIRCUITS**

(30) Priority: 22.02.2024 US 202418584339
(71) Applicant: Altera Corporation, San Jose, CA 95134 (US)
(72) Inventor: KINSNER, Michael, Halifax, B3N1R3 (CA); SINCLAIR, Byron, Toronto, M6K2M4 (CA); NASH, Gregory, Barrington, 60010 (US)
(74) Representative: Viering, Jentschura & Partner mbB Patent- und Rechtsanwälte

(57) **Abstract**

An integrated circuit includes configurable logic circuit blocks (201-204) that are configurable with a first configuration bitstream according to a coarse grained configuration. The coarse grained configuration implements an aggregate circuit structure of the configurable logic circuit blocks. The configurable logic circuit blocks are configurable with a second configuration bitstream according to a fine grained configuration. A total number of the first and the second configuration bits is fewer than a single fine grained configuration bitstream.

## Description

### TECHNICAL FIELD

The present disclosure relates to electronic integrated circuits, and more particularly, to techniques for coarse grained and fine grained configurations of configurable logic circuits in an integrated circuit.

### BACKGROUND

Configurable integrated circuits can be configured by users to implement desired custom logic functions. In a typical scenario, a logic designer uses computer-aided design (CAD) tools to design a custom circuit design. When the design process is complete, the computer-aided design tools generate configuration data containing configuration bits. The configuration data is then loaded into configuration memory elements that configure configurable logic circuits in the integrated circuit to perform the functions of the custom circuit design. Configurable integrated circuits can be used for co-processing in big-data or fast-data applications. For example, configurable integrated circuits can used in application acceleration tasks in a datacenter and can be reprogrammed during datacenter operation to perform different tasks.

### BRIEF DESCRIPTION OF DRAWINGS

Figure 1 is a diagram that depicts examples of configurable logic circuit blocks in a configurable integrated circuit (IC) that can be configured with a reduced configuration bitstream.
Figure 2 is a diagram that depicts examples of configurable logic circuit blocks in a configurable integrated circuit (IC) that can be configured with multiple sets of reduced configuration bitstreams.
Figure 3 is a diagram that depicts an example of a circuit system including a state machine that controls configuration of configurable logic circuit blocks using a reduced configuration bitstream.
Figure 4 is a diagram of an illustrative example of a configurable integrated circuit (IC).
Figure 5 illustrates a block diagram of a system that can be used to implement a circuit design to be programmed onto a programmable logic device using design software.
Figure 6 is a diagram that depicts an example of a programmable logic device that includes a fabric die and a base die that are connected to one another via microbumps.
Figure 7 is a block diagram illustrating a computing system configured to implement one or more aspects of the embodiments described herein.

### DETAILED DESCRIPTION

The configuration of configurable integrated circuits (ICs) is often slower than the targets required by many applications that use data-driven time domain multiplexing of functionality for signals processing. The configuration of configurable integrated circuits is also often too slow for dynamic pipeline load balancing in packet processing applications, such as deep packet inspection for intrusion detection. The configuration and reconfiguration of configurable integrated circuits is often slow relative to application requirements in part because of the fine grained structure of configurable integrated circuits (e.g., individual lookup table bit settings). The fine grained structure of configurable integrated circuits provides the benefits of flexibility and efficiency, but can cause longer configuration times than are tractable for dynamic in-situ load balancing or data responsive functionality swaps in signals applications. Configuration time is particularly important when all functionality of a circuit design cannot fit in a single configurable integrated circuit and needs to be either time multiplexed, or additional configurable integrated circuits need to be added to the system, which substantially increases total cost of the system.

According to some examples disclosed herein, a multi-scale configuration approach is provided that enables fast configuration times for a subset of more commonly used functionality on a configurable integrated circuit (IC), while also providing slower fine grained configurability advantages. Coarse grained configurations of aggregate configurable circuit structures on the configurable IC are activated through reduced configuration bitstream transfers (e.g., of a few configuration bits), allowing commonly used larger scale structures to be manifested on fine grained circuitry with many orders of magnitude fewer configuration bits and reduced configuration time.

Some of the techniques disclosed herein can enable time multiplexing of functionality in configurable integrated circuits at faster rates (e.g., finer practical time slices). Some of the techniques disclosed herein can enable new use models for configurable integrated circuits, such as data-driven dynamic spatial load balancing. Some of the techniques disclosed herein can reduce the size of devices required for a custom circuit design through hardware reuse (e.g., time division reconfiguration), can make programming paradigms more compatible for configurable integrated circuits, and can remove barriers for configurable integrated circuits, such as a custom circuit design not fitting a configurable integrated circuit.

One or more specific examples are described below. In an effort to provide a concise description of these examples, not all features of an actual implementation are described in the specification. It should be appreciated that in the development of any such actual implementation, as in any engineering or design project, numerous implementation-specific decisions must be made to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill having the benefit of this disclosure.

Throughout the specification, and in the claims, the term "connected" means a direct electrical connection between the circuits that are connected, without any intermediary devices. The term "coupled" means either a direct electrical connection between circuits or an indirect electrical connection through one or more passive or active intermediary devices that allows the transfer of information between circuits. The term "circuit" may mean one or more passive and/or active electrical components that are arranged to cooperate with one another to provide a desired function.

This disclosure discusses integrated circuit devices, including configurable (programmable) logic integrated circuits, such as field programmable gate arrays (FPGAs). As discussed herein, an integrated circuit (IC) can include hard logic and/or soft logic. The circuits in an integrated circuit device (e.g., in a configurable logic IC) that are configurable by an end user are referred to as "soft logic." "Hard logic" generally refers to circuits in an integrated circuit device that have substantially less configurable features than soft logic or no configurable features.

According to some techniques disclosed herein, the size of a configuration bitstream for a configurable IC is reduced where commonly used aggregate functions (e.g., commonly used data width additions using carry chains) are used in a custom circuit design to enable much faster configuration, reconfiguration, and partial reconfiguration of the configurable IC. The commonly used aggregate functions can be used in custom circuit designs for many applications, such as artificial intelligence workloads, infrastructure processing workloads, and higher level languages feeding into design flows for configurable integrated circuits (ICs). Custom circuit designs for configurable ICs are also referred to herein as user designs or simply as circuit designs.

Configurable integrated circuits (ICs) typically have very fine grained configurability. The fine granularity of configurability means that many configuration bits are set to implement a user design in a configurable IC. Custom logic functions in a user design are typically compositions of multiple design units that are mapped to many configurable logic circuit blocks in a configurable IC.

Standard operators implemented in fine grained configurable logic circuits are increasingly common in circuit designs, such as within artificial intelligence workloads, infrastructure processing unit workloads, and higher level design input mechanisms. For example, a 32-bit adder can be created from an aggregate configuration of arithmetic configurable logic circuits configured with a carry chain. Some of the standard operators can be implemented by hard logic in a configurable IC. However, only a small subset of commonly used functions can exist within hard logic without degrading the fine grained configurability of a configurable IC.

According to some exemplary implementations disclosed herein, a configurable IC (or a portion thereof) is configured using a reduced configuration bitstream having less configuration bits. The reduced configuration bitstream enables larger scale configurations of a configurable IC to be achieved without transmitting fine grained configuration bits. Larger scale circuit structures comprising multiple configuration settings within a single configurable logic circuit block, and/or multiple configurable logic circuit blocks forming an aggregate structure, are configured with a much smaller configuration bitstream. The reduced bitstream size for the larger scale circuit structures leverages the underlying fine grained architecture of a configurable IC, but without the explicit configuration bitstream for a circuit design that sets the configuration bits for each of the fine grained elements in the configurable IC.

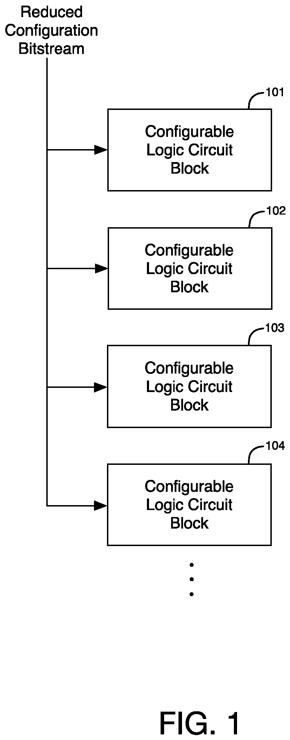

Figure 1 is a diagram that depicts examples of configurable logic circuit blocks in a configurable integrated circuit (IC) that can be configured with a reduced configuration bitstream. Figure (FIG.) 1 illustrates 4 configurable logic circuit blocks 101-104 in a single configurable IC, such as a field programmable gate array (FPGA) or a programmable logic device (PLD). Only 4 configurable logic circuit blocks 101-104 are shown in FIG. 1 as an example. Although the configurable IC can have any number of configurable logic circuit blocks that are configured with a reduced configuration bitstream. As examples, the configurable logic circuit blocks 101-104 can include one or more of configurable arithmetic circuit blocks (e.g., configurable logic adder circuits), adaptive logic modules (ALMs), configurable digital signal processing circuit blocks, configurable memory blocks, blocks of lookup tables, etc.

In the example of FIG. 1, a reduced configuration bitstream is provided to each of the configurable logic circuit blocks 101, 102, 103, and 104. The reduced configuration bitstream contains configuration bits that are used to configure coarse grained functionality of configurable logic circuits in the configurable logic circuit blocks 101-104. The reduced configuration bitstream is used to provide coarse grained configurations of the configurable logic circuit blocks 101-104 to generate an aggregate circuit structure.

The reduced configuration bitstream contains less than all of the configuration bits that are needed to configure all of the configurable functionality of the configurable logic circuit blocks 101-104. The reduced configuration bitstream can also include control information (e.g., fast configuration activation codes in a header) that indicates that the reduced configuration bitstream contains only the coarse grained configurations for the configurable logic circuit blocks 101-104. The remainder of the configuration bits that are used for providing the fine grained configuration for the configurable logic circuit blocks 101-104 are accessed from another source, examples of which are described below. The configurable logic circuits in the configurable logic circuit blocks 101-104 are then configured with the remainder of the configuration bits according to fine grained configurations to provide fine grained functionality.

The reduced configuration bitstream can, for example, contain only a small fraction of the configuration bits needed to configure the full functionality of each of the configurable logic circuit blocks 101-104 to provide fast configuration speed for the coarse grained functionality. As a more specific example that is provided as an illustration and is not intended to be limiting, the reduced configuration bitstream can contain an N number of configuration bits for configuring configurable logic circuit blocks 101-104 to implement an M-bit wide adder circuit, where N and M are positive non-zero integers. In this example, the configurable logic circuit blocks 101-104 are coupled together using carry chains to implement the adder circuit.

In some implementations of FIG. 1, the configurable logic circuit blocks 101-104 can include two or more different types of configurable logic circuit blocks. As examples, the two or more different types of configurable logic circuit blocks 101-104 can include one or more configurable arithmetic circuit blocks, one or more adaptive logic modules (ALMs), one or more configurable digital signal processing (DSP) circuit blocks, one or more configurable memory blocks, and/or one or more blocks of configurable lookup tables.

According to various examples, the reduced configuration bitstreams disclosed herein can be used for the initial configuration of a configurable IC, full device reconfiguration of a configurable IC, or partial reconfiguration of any region of a configurable IC, including the core region and/or the peripheral region of the IC. The reduced configuration bitstream of FIG. 1 can activate commonly used configurations corresponding to larger sets of configuration bits that are accessed and used to configure the remainder of the fine grained functionality of the configurable logic circuit blocks 101-104.

The commonly used configurations that can be activated with fewer configuration bits in the reduced configuration bitstream can be accessed through various user design entry interfaces. As an example, computer aided design (CAD) software running on a computer system can generate an automatic inference from a user design for a configurable IC and an optional extraction of commonly used design elements from the user design to form sets of configuration bits for commonly used configurations that are accessed through ultra-fast configuration (depending on the implementation approach). As another example, user designs for configurable ICs can explicitly instantiate commonly used configurations containing configuration bits, for example, as intellectual property (IP) instances with a register transfer level (RTL) design file.

As yet another example, design entry methods for a user design can include sets of configuration bits for commonly used configurations, such as a function call in a high-level programming language or specific functions within a domain specific language. As another example, design entry methods for a user design can include sets of configuration bits corresponding to commonly used configurations for design patterns for the user design, such as a high-level programming language where only the built-in data types and math operators on those data types are available, or a domain specific programming language with a restricted set of operators on a restricted set of data types. According to other examples, any combination of the previously discussed techniques can be used to access the configuration bits for the commonly used configurations.

Depending on the implementation approach for a user design, an aggregate or large scale function in a user design can be decomposed into intermediate scale blocks that are aligned with configurable logic circuit blocks in a configurable IC (e.g., ALMs or other physical circuit structures). A reduced configuration bitstream can be used to provide fast configuration of configurable logic circuit blocks to implement commonly used functions of constituent intermediate scale blocks in a user design, allowing placement flexibility across implementation approaches, while substantially increasing the configuration speed of the configurable logic circuit blocks. The intermediate scale configuration can be used with arbitrary levels of scale decomposition, providing hierarchical or multi-scale configuration of sets of aggregate resources on an IC. This approach allows the configuration time to scale as the IC deviates from the use of commonly used functionality blocks, because some commonly used intermediate scale building blocks can be composed with custom fine grained region configuration.

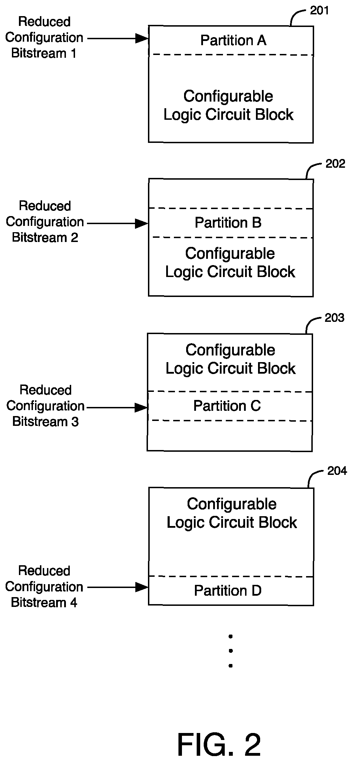

Figure 2 is a diagram that depicts examples of configurable logic circuit blocks in a configurable integrated circuit (IC) that can be configured with multiple sets of reduced configuration bitstreams. FIG. 2 illustrates 4 configurable logic circuit blocks 201-204 in a single configurable IC, such as an FPGA or a PLD. Only 4 configurable logic circuit blocks 201-204 are shown in FIG. 2 as an example. Although the configurable IC can have any number of configurable logic circuit blocks that are configured with reduced size configuration bitstreams. As examples, configurable logic circuit blocks 201-204 can include one or more of configurable arithmetic circuit blocks (e.g., configurable logic adder circuits), adaptive logic modules (ALMs), configurable digital signal processing circuit blocks, configurable memory blocks, blocks of lookup tables, etc.

In the example of FIG. 2, an aggregate function in a user design for the configurable IC is decomposed into 4 intermediate scale blocks that are mapped to the 4 configurable logic circuit blocks 201-204. Four reduced configuration bitstreams (1, 2, 3, and 4) are generated for implementing the aggregate function in the configurable logic circuit blocks 201-204. The four reduced configuration bitstreams 1-4 are provided to the configurable logic circuit blocks 201, 202, 203, and 204, respectively, as shown in FIG. 2, during configuration.

Each of the four configurable logic circuit blocks 201, 202, 203, and 204 is divided into 4 partitions. FIG. 2 shows only one of the 4 partitions in each of the configurable logic circuit blocks 201, 202, 203, and 204. Specifically, FIG. 2 shows partitions A, B, C, and D in configurable logic circuit blocks 201, 202, 203, and 204, respectively. The reduced configuration bitstreams 1, 2, 3, and 4 contain configuration bits that are used to configure coarse grained functionality of configurable logic circuits in partitions A, B, C, and D of configurable logic circuit blocks 201, 202, 203, and 204, respectively. The reduced configuration bitstreams 1-4 are used to provide coarse grained configurations for generating a combined configuration that implements the aggregate function in the user design. Thus, coarse grained functions of the configurable logic circuits in partitions A, B, C, and D of the configurable logic circuit blocks 201, 202, 203, and 204 are configured using the reduced configuration bitstreams 1, 2, 3, and 4, respectively.

The reduced configuration bitstreams 1-4 contain less than all of the configuration bits that are needed to configure all of the configurable functionality of the partitions A-D in configurable logic circuit blocks 201-204, respectively. The reduced configuration bitstreams 1-4 can also include control information that indicates that the reduced configuration bitstreams 1-4 only have coarse grained configurations. The remainder of the configuration bits that are used for providing the fine grained configurations for configurable logic circuit blocks 201-204 are accessed from one or more other sources, examples of which are described below. The configurable logic circuits in partitions A, B, C, and D of the configurable logic circuit blocks 201-204, respectively, are then configured with the remainder of the configuration bits according to fine grained configurations to provide fine grained functionality.

As a specific example that is provided as an illustration and is not intended to be limiting, each of the 4 reduced configuration bitstreams 1-4 can, for example, contain a different set of N configuration bits for configuring a respective partition A-D of the configurable logic circuit blocks 201-204 to implement an M-bit wide adder circuit. In this example, configurable logic circuit blocks 201-204 are coupled together using carry chains to implement the adder circuit.

According to other exemplary implementations, a reduced configuration bitstream can optionally include the specific configuration bits for changing the configuration of one or more configurable logic circuit blocks that have already been configured. As an example, a reduced configuration bitstream can include only the configuration bits that are needed to change a commonly used circuit block from addition (i.e., an adder) into subtraction (i.e., a subtractor). As another example, a reduced configuration bitstream can include only the configuration bits that are needed to disconnect a carry chain in an adder at one specific point in the adder to create a dual N-bit adder instead of a single 2N-bit adder. The combination of commonly used larger scale circuit structures with fine grained configuration adjustments allows the flexibility and adaptability of a configurable IC to be maintained, while providing large decreases in the configuration time, and effectively expanding the ultra-fast configuration library size (of commonly used configurations) without a combinatorial increase of the number of entries in the library.

Additionally, other exemplary implementations can be used to reduce the configuration time for configuring configurable logic circuit blocks in a configurable IC or in other types of ICs. For example, hardware structures can be constructed so that reduced (e.g., small) sets of configuration bits (and optionally negations of the configuration bits) fanout to many configuration bit memory cells that configure configurable logic circuit blocks to implement commonly used larger scale functionality using a fast mechanism and with fewer configuration bits. In these implementations, a configurable IC can include circuitry for providing configuration bit settings that are activated (e.g., through configuration multiplexers) to configure configurable logic circuit blocks with configuration bitstreams, even when the configuration bitstreams do not include fast configuration activation codes that indicate reduced configuration bitstreams.

According to yet another exemplary implementation, a state machine implemented by a localized hardened circuit block, a processor, firmware, or software in a configurable IC can receive a reduced configuration bitstream for configuring configurable logic circuit blocks in the IC. The state machine can then transfer the remaining configuration bits needed for configuring the configurable logic circuit blocks (e.g., the fine grained configuration bits) from locally accessible memory (e.g., local memory or parallel external memory on a separate IC) through a configuration network to the configurable logic circuit blocks. The state machine can also transfer the reduced configuration bitstream to the configurable logic circuit blocks.

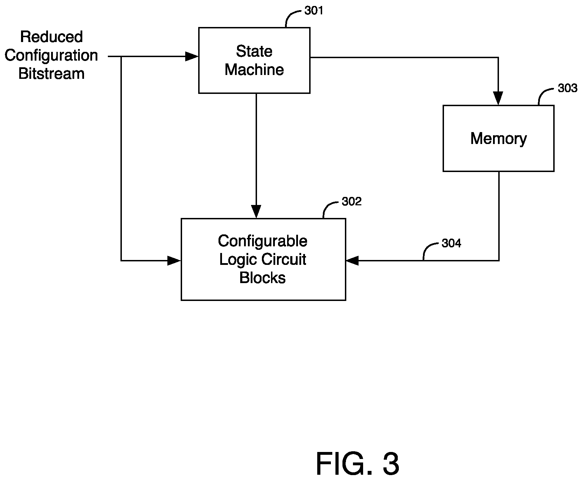

Figure 3 is a diagram that depicts an example of a circuit system including a state machine that controls configuration of configurable logic circuit blocks using a reduced configuration bitstream. The circuit system of FIG. 3 includes a state machine 301, configurable logic circuit blocks 302, and memory circuit 303. In some implementations, state machine 301, configurable logic circuit blocks 302, and memory circuit 303 are in a single configurable IC. In other implementations, state machine 301 and configurable logic circuit blocks 302 are in a single configurable IC, and memory circuit 303 is in a separate IC. The state machine 301 can be implemented by a hardened circuit block, a processor, firmware, software, etc.

The state machine 301 receives a reduced configuration bitstream. The reduced configuration bitstream is used for configuring coarse grained functionality of the configurable logic circuit blocks 302 in the configurable IC. The state machine 301 can provide the reduced configuration bitstream to the memory circuit 303, or the reduced configuration bitstream can be provided directly to the configurable logic circuit blocks 302 from the state machine 301. If the reduced configuration bitstream is provided to and stored in memory circuit 303, memory circuit 303 subsequently provides the reduced configuration bitstream to the configurable logic circuit blocks 302 through a configuration network 304. Configurable logic circuit blocks 302 are configured with the reduced configuration bitstream to provide coarse grained functionality for a coarse grained configuration.

Memory circuit 303 stores the remaining configuration bits (e.g., the fine grained or intermediate scale configuration bits) needed for configuring the fine grained and/or intermediate scale functionality of the configurable logic circuit blocks 302. In response to receiving the reduced configuration bitstream, state machine 301 sends a signal to memory circuit 303 to cause memory circuit 303 to transfer the remaining configuration bits needed for configuring configurable logic circuit blocks 302 through configuration network 304 to configurable logic circuit blocks 302. Configurable logic circuit blocks 302 are then configured with the remaining configuration bits to provide fine grained and/or intermediate scale functionality for a fine grained and/or intermediate scale configuration. Configuration network 304 can be, for example, a network-on-chip (NOC).

According to yet another exemplary implementation, reduced configuration bitstreams containing encoded commonly used patterns can be generated and used for fast configuration of configurable logic circuit blocks in an IC. The encoded commonly used patterns can be decoded to generate fine grained or intermediate scale configuration bits for classes of user designs being programmed on the IC. Alternatively, the encoded commonly used patterns can indicate where fine grained or intermediate scale configuration bits are stored for the classes of user designs being programmed on the IC. The fine grained or intermediate scale configuration bits are used to configure fine grained or intermediate scale functionality of the configurable logic circuit blocks. One or more memory circuits, such as specialized configuration-only buffers in the IC or three-dimensional (3D) memory ICs, can store or be programmed with the fine grained or intermediate scale configuration bits. CAD software can, for example, generate the reduced configuration bitstreams that determine multi-scale fast configurations for the configurable logic circuit blocks, instead of the configurations being fixed in the hardware or firmware of the IC.

As other examples, the fine grained or intermediate scale configuration bits used for fully implementing the fast configurations indicated by the reduced configuration bitstreams can be stored in one or more off-chip high-speed parallel memory ICs that are external to the configurable IC. The configurable IC can include one or more high-speed parallel transport networks (e.g., a NOC) that provide fast parallel configuration for the commonly used patterns that are configured using the fine grained or intermediate scale configuration bits.

As yet other examples, the configurable IC can include a single level or multiple levels of caching in a NOC or in memory subsystems that allow commonly used configurations for a specific user design (e.g., configuration bits) to be stored and available for use in implementing high-speed configuration of the configurable logic circuit blocks. The implementations and examples described herein are not mutually exclusive and can be combined in any desired combinations, including at different, or in the same, spatial scales of configuration.

In various implementations, a set of commonly used larger scale circuit structures can be extracted from a user design by CAD software, extracted from libraries of custom design sets as an optimization problem relative to the circuit designs that can be configured in a configurable IC, defined by a vendor or customer as libraries of available fast configuration patterns, or made to align with design intent input mechanisms, such as in various programming languages. The set of commonly used larger scale circuit structures can then be used to generate the reduced configuration bitstreams.

In some exemplary implementations, the reduced configuration bitstreams can be encoded using shorter patterns for commonly used aggregate scale configurations of the configurable logic circuit blocks. The reduced configuration bitstreams can be encoded using any bitstream encoding or information theory and techniques, such as entropy coding or Huffman coding. The reduced configuration bitstreams can also or alternatively be compressed using many different techniques for data compression. The state machine 301 of FIG. 3 can decode or decompress the reduced configuration bitstream and provide the decoded or decompressed configuration bitstream to the configurable logic circuit blocks. The reduced configuration bitstreams can also support coarse grained perturbation or coarse grained region configuration of the configurable logic circuit blocks, in addition to being compressed and/or encoded.

The various examples and implementations disclosed herein for fast configuration using reduced configuration bitstreams address critical challenges of using configurable ICs. These challenges can include, for example, user designs not fitting a configurable IC or needing extensive optimization, needing multiple configurable ICs to fit a user design, the inability to load balance or have data-driven functionality adaptation at fine enough time scales, and configuration bitstream storage challenges. The examples and implementations disclosed herein make configurable ICs applicable and competitive for a variety of different workloads.

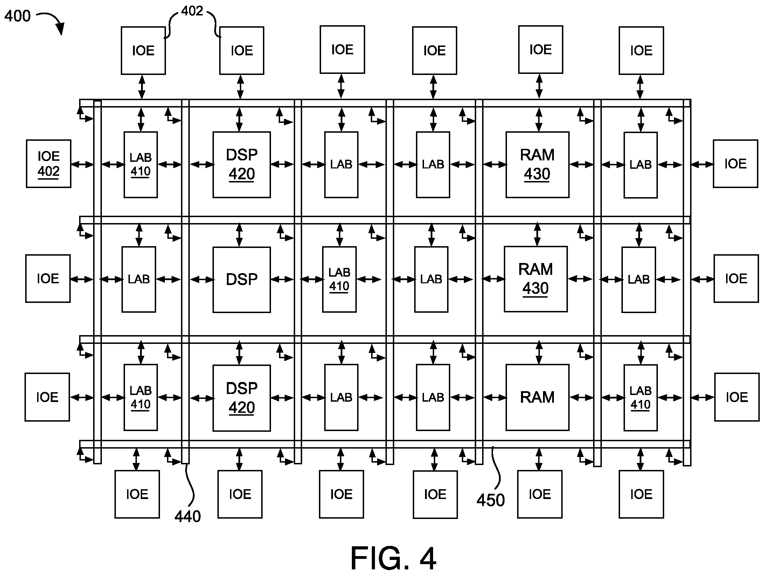

Figure 4 is a diagram of an illustrative example of a configurable integrated circuit (IC) 400. Configurable IC 400 is an example of an IC that can include the circuitry disclosed herein with respect to Figures 1, 2 and/or 3. As shown in FIG. 4, the configurable integrated circuit 400 includes a two-dimensional array of configurable logic circuit blocks, including logic array blocks (LABs) 410 and other configurable logic circuit blocks, such as random access memory (RAM) blocks 430 and digital signal processing (DSP) blocks 420, for example. Configurable logic circuit blocks, such as LABs 410, can include smaller configurable regions (e.g., configurable logic elements, configurable logic blocks, or adaptive logic modules (ALMs)) that receive input signals and perform custom functions on the input signals to produce output signals. The configurable logic circuit blocks disclosed herein with respect to FIGS. 1-3 can include, for example, LABs 410, DSP blocks 420, and/or RAM 430.

The configurable integrated circuit 400 also includes programmable interconnect circuitry in the form of vertical routing channels 440 (i.e., interconnects formed along a vertical axis of configurable integrated circuit 400) and horizontal routing channels 450 (i.e., interconnects formed along a horizontal axis of configurable integrated circuit 400), each routing channel including at least one track to route at least one wire. One or more of the routing channels 440 and/or 450 can be part of a network-on-chip (NOC) having router circuits.

In addition, the configurable integrated circuit 400 has input/output elements (IOEs) 402 for driving signals off of configurable integrated circuit 400 and for receiving signals from other devices. Input/output elements 402 can include parallel input/output circuitry, serial data transceiver circuitry, differential receiver and transmitter circuitry, or other circuitry used to connect one integrated circuit to another integrated circuit. Input/output elements 402 can include general purpose input/output (GPIO) circuitry (e.g., on the top and bottoms edges of IC 400), high-speed input/output (HSIO) circuitry (e.g., on the left edge of IC 400), and on-package input/output (OPIOs) circuitry (e.g., on the right edge of IC 400).

As shown, input/output elements 402 can be located around the periphery of the IC. If desired, the configurable integrated circuit 400 can have input/output elements 402 arranged in different ways. For example, input/output elements 402 can form one or more columns of input/output elements that can be located anywhere on the configurable integrated circuit 400 (e.g., distributed evenly across the width of the configurable integrated circuit). If desired, input/output elements 402 can form one or more rows of input/output elements (e.g., distributed across the height of the configurable integrated circuit). Alternatively, input/output elements 402 can form islands of input/output elements that can be distributed over the surface of the configurable integrated circuit 400 or clustered in selected areas.

Note that other routing topologies, besides the topology of the interconnect circuitry depicted in FIG. 4, can be used. For example, the routing topology can include wires that travel diagonally or that travel horizontally and vertically along different parts of their extent as well as wires that are perpendicular to the device plane in the case of three dimensional integrated circuits, and the driver of a wire can be located at a different point than one end of a wire. The routing topology can include global wires that span substantially all of configurable integrated circuit 400, fractional global wires such as wires that span part of configurable integrated circuit 400, staggered wires of a particular length, smaller local wires, or any other suitable interconnection resource arrangement.

Furthermore, it should be understood that examples disclosed herein may be implemented in any type of integrated circuit. If desired, the functional blocks of such an integrated circuit can be arranged in more levels or layers in which multiple functional blocks are interconnected to form still larger blocks. Other device arrangements can use functional blocks that are not arranged in rows and columns.

Configurable integrated circuit 400 can also contain programmable memory elements. The memory elements can be loaded with configuration data (also called programming data) using input/output elements (IOEs) 402. Once loaded, the memory elements each provide a corresponding static control signal that controls the operation of an associated functional block (e.g., LABs 410, DSP 420, RAM 430, or input/output elements 402).

In a typical scenario, the outputs of the loaded memory elements are applied to the gates of field-effect transistors in a functional block to turn certain transistors on or off and thereby configure the logic in the functional block including the routing paths. Programmable logic circuit elements that are controlled in this way include parts of multiplexers (e.g., multiplexers used for forming routing paths in interconnect circuits), look-up tables, logic arrays, AND, OR, NAND, and NOR logic gates, pass gates, etc.

The memory elements can use any suitable volatile and/or non-volatile memory structures such as random-access-memory (RAM) cells, fuses, antifuses, programmable read-only-memory memory cells, mask-programmed and laser-programmed structures, combinations of these structures, etc. Because the memory elements are loaded with configuration data during programming, the memory elements are sometimes referred to as configuration memory or programmable memory elements.

The programmable memory elements can be organized in a configuration memory array consisting of rows and columns. A data register that spans across all columns and an address register that spans across all rows can receive configuration data. The configuration data can be shifted onto the data register. When the appropriate address register is asserted, the data register writes the configuration data to the configuration memory elements of the row that was designated by the address register.

Configurable integrated circuit 400 can include configuration memory that is organized in sectors, whereby a sector can include the configuration bits that specify the function and/or interconnections of the subcomponents and wires in or crossing that sector. Each sector can include separate data and address registers.

The configurable IC 400 of FIG. 4 is merely one example of an IC that can be used with embodiments disclosed herein. The embodiments disclosed herein can be used with any suitable electronic integrated circuit or system. For example, the embodiments disclosed herein can be used with numerous types of electronic devices such as processor integrated circuits, central processing units, memory integrated circuits, graphics processing unit integrated circuits, application specific standard products (ASSPs), application specific integrated circuits (ASICs), and configurable logic integrated circuits. Examples of configurable logic integrated circuits include programmable arrays logic (PALs), programmable logic arrays (PLAs), field programmable logic arrays (FPLAs), electrically programmable logic devices (EPLDs), electrically erasable programmable logic devices (EEPLDs), logic cell arrays (LCAs), complex programmable logic devices (CPLDs), and field programmable gate arrays (FPGAs), just to name a few.

The integrated circuits disclosed in one or more embodiments herein can be part of a data processing system that includes one or more of the following components: a processor; memory; input/output circuitry; and peripheral devices. The data processing system can be used in a wide variety of applications, such as computer networking, data networking, instrumentation, video processing, digital signal processing, or any suitable other application. The integrated circuits can be used to perform a variety of different logic functions.

In general, software and data for performing any of the functions disclosed herein can be stored in non-transitory computer readable storage media. Non-transitory computer readable storage media is tangible computer readable storage media that stores data and software for access at a later time, as opposed to media that only transmits propagating electrical signals (e.g., wires). The software code may sometimes be referred to as software, data, program instructions, instructions, or code. The non-transitory computer readable storage media can, for example, include computer memory chips, non-volatile memory such as non-volatile random-access memory (NVRAM), one or more hard drives (e.g., magnetic drives or solid state drives), one or more removable flash drives or other removable media, compact discs (CDs), digital versatile discs (DVDs), Blu-ray discs (BDs), other optical media, and floppy diskettes, tapes, or any other suitable memory or storage device(s).

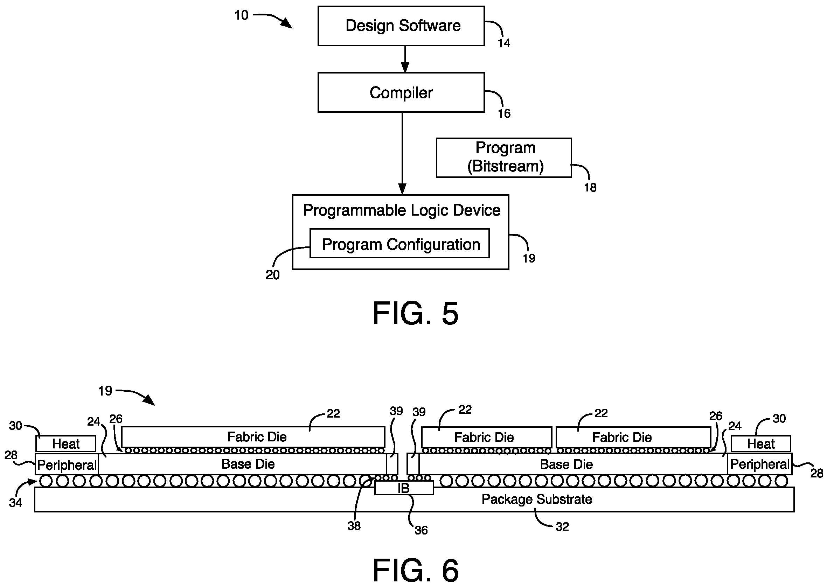

Figure 5 illustrates a block diagram of a system 10 that can be used to implement a circuit design to be programmed onto a programmable logic device 19 using design software. A designer can implement circuit design functionality on an integrated circuit, such as a reconfigurable programmable logic device 19 (e.g., a field programmable gate array (FPGA)). The designer can implement the circuit design to be programmed onto the programmable logic device 19 using design software 14. The design software 14 can use a compiler 16 to generate a low-level circuit-design program (bitstream) 18, sometimes known as a program object file and/or configuration program, that programs the programmable logic device 19. Thus, the compiler 16 can provide machine-readable instructions representative of the circuit design to the programmable logic device 19. For example, the programmable logic device 19 can receive one or more programs (bitstreams) 18 that describe the hardware implementations that should be stored in the programmable logic device 19. A program (bitstream) 18 can be programmed into the programmable logic device 19 as a configuration program 20. The configuration program 20 can, in some cases, represent an accelerator function to perform for machine learning, video processing, voice recognition, image recognition, or other highly specialized task.

In some implementations, a programmable logic device can be any integrated circuit device that includes a programmable logic device with two separate integrated circuit die where at least some of the programmable logic fabric is separated from at least some of the fabric support circuitry that operates the programmable logic fabric. One example of such a programmable logic device is shown in FIG. 6, but many others can be used, and it should be understood that this disclosure is intended to encompass any suitable programmable logic device where programmable logic fabric and fabric support circuitry are at least partially separated on different integrated circuit die.

Figure 6 is a diagram that depicts an example of the programmable logic device 19 that includes three fabric die 22 and two base die 24 that are connected to one another via microbumps 26. In the example of FIG. 6, at least some of the programmable logic fabric of the programmable logic device 19 is in the three fabric die 22, and at least some of the fabric support circuitry that operates the programmable logic fabric is in the two base die 24. For example, some of the circuitry of configurable IC 400 shown in FIG. 4 (e.g., LABs 410, DSP 420, and RAM 430) can be located in the fabric die 22 and some of the circuitry of IC 400 (e.g., input/output elements 402) can be located in the base die 24.

Although the fabric die 22 and base die 24 appear in a one-to-one relationship or a two-to-one relationship in FIG. 6, other relationships can be used. For example, a single base die 24 can attach to several fabric die 22, or several base die 24 can attach to a single fabric die 22, or several base die 24 can attach to several fabric die 22 (e.g., in an interleaved pattern). Peripheral circuitry 28 can be attached to, embedded within, and/or disposed on top of the base die 24, and heat spreaders 30 can be used to reduce an accumulation of heat on the programmable logic device 19. The heat spreaders 30 can appear above, as pictured, and/or below the package (e.g., as a double-sided heat sink). The base die 24 can attach to a package substrate 32 via conductive bumps 34. In the example of FIG. 6, two pairs of fabric die 22 and base die 24 are shown communicatively connected to one another via an interconnect bridge 36 (e.g., an embedded multi-die interconnect bridge (EMIB)) and microbumps 38 at bridge interfaces 39 in base die 24.

In combination, the fabric die 22 and the base die 24 can operate in combination as a programmable logic device 19 such as a field programmable gate array (FPGA). It should be understood that an FPGA can, for example, represent the type of circuitry, and/or a logical arrangement, of a programmable logic device when both the fabric die 22 and the base die 24 operate in combination. Moreover, an FPGA is discussed herein for the purposes of this example, though it should be understood that any suitable type of programmable logic device can be used.

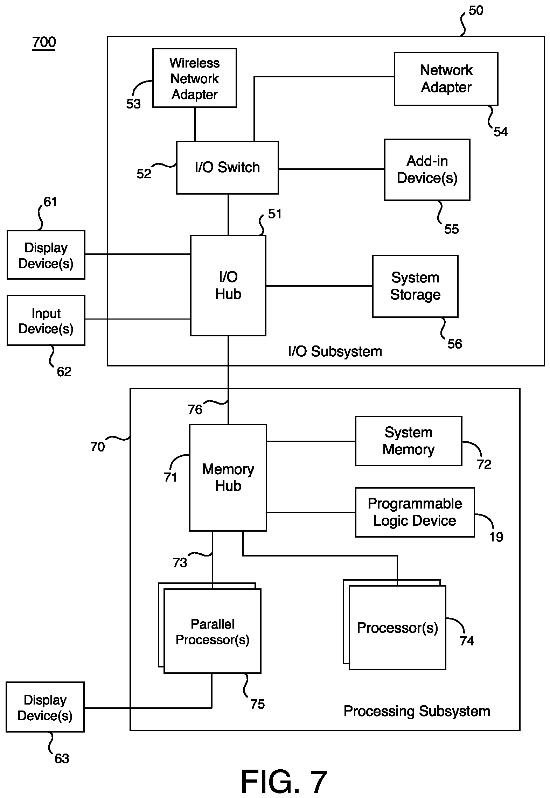

Figure 7 is a block diagram illustrating a computing system 700 configured to implement one or more aspects of the embodiments described herein. The computing system 700 includes a processing subsystem 70 having one or more processor(s) 74, a system memory 72, and a programmable logic device 19 communicating via an interconnection path that can include a memory hub 71. The memory hub 71 can be a separate component within a chipset component or can be integrated within the one or more processor(s) 74. The memory hub 71 couples with an input/output (I/O) subsystem 50 via a communication link 76. The I/O subsystem 50 includes an input/output (I/O) hub 51 that can enable the computing system 700 to receive input from one or more input device(s) 62. Additionally, the I/O hub 51 can enable a display controller, which can be included in the one or more processor(s) 74, to provide outputs to one or more display device(s) 61. In one embodiment, the one or more display device(s) 61 coupled with the I/O hub 51 can include a local, internal, or embedded display device.

In one embodiment, the processing subsystem 70 includes one or more parallel processor(s) 75 coupled to memory hub 71 via a bus or other communication link 73. The communication link 73 can use one of any number of standards based communication link technologies or protocols, such as, but not limited to, PCI Express, or can be a vendor specific communications interface or communications fabric. In one embodiment, the one or more parallel processor(s) 75 form a computationally focused parallel or vector processing system that can include a large number of processing cores and/or processing clusters, such as a many integrated core (MIC) processor. In one embodiment, the one or more parallel processor(s) 75 form a graphics processing subsystem that can output pixels to one of the one or more display device(s) 61 coupled via the I/O Hub 51. The one or more parallel processor(s) 75 can also include a display controller and display interface (not shown) to enable a direct connection to one or more display device(s) 63.

Within the I/O subsystem 50, a system storage unit 56 can connect to the I/O hub 51 to provide a storage mechanism for the computing system 700. An I/O switch 52 can be used to provide an interface mechanism to enable connections between the I/O hub 51 and other components, such as a network adapter 54 and/or a wireless network adapter 53 that can be integrated into the platform, and various other devices that can be added via one or more add-in device(s) 55. The network adapter 54 can be an Ethernet adapter or another wired network adapter. The wireless network adapter 53 can include one or more of a Wi-Fi, Bluetooth, near field communication (NFC), or other network device that includes one or more wireless radios.

The computing system 700 can include other components not shown in FIG. 7, including other port connections, optical storage drives, video capture devices, and the like, that can also be connected to the I/O hub 51. Communication paths interconnecting the various components in FIG. 7 can be implemented using any suitable protocols, such as PCI (Peripheral Component Interconnect) based protocols (e.g., PCI-Express), or any other bus or point-to-point communication interfaces and/or protocol(s), such as the NV-Link high-speed interconnect, or interconnect protocols known in the art.

In one embodiment, the one or more parallel processor(s) 75 incorporate circuitry optimized for graphics and video processing, including, for example, video output circuitry, and constitutes a graphics processing unit (GPU). In another embodiment, the one or more parallel processor(s) 75 incorporate circuitry optimized for general purpose processing, while preserving the underlying computational architecture. In yet another embodiment, components of the computing system 700 can be integrated with one or more other system elements on a single integrated circuit. For example, the one or more parallel processor(s) 75, memory hub 71, processor(s) 74, and I/O hub 51 can be integrated into a system on chip (SoC) integrated circuit. Alternatively, the components of the computing system 700 can be integrated into a single package to form a system in package (SIP) configuration. In one embodiment, at least a portion of the components of the computing system 700 can be integrated into a multi-chip module (MCM), which can be interconnected with other multi-chip modules into a modular computing system.

The computing system 700 shown herein is illustrative. Other variations and modifications are also possible. The connection topology, including the number and arrangement of bridges, the number of processor(s) 74, and the number of parallel processor(s) 75, can be modified as desired. For instance, in some embodiments, system memory 72 is connected to the processor(s) 74 directly rather than through a bridge, while other devices communicate with system memory 72 via the memory hub 71 and the processor(s) 74. In other alternative topologies, the parallel processor(s) 75 are connected to the I/O hub 51 or directly to one of the one or more processor(s) 74, rather than to the memory hub 71. In other embodiments, the I/O hub 51 and memory hub 71 can be integrated into a single chip. Some embodiments can include two or more sets of processor(s) 74 attached via multiple sockets, which can couple with two or more instances of the parallel processor(s) 75.

Some of the particular components shown herein are optional and may not be included in all implementations of the computing system 700. For example, any number of add-in cards or peripherals can be supported, or some components can be eliminated. Furthermore, some architectures can use different terminology for components similar to those illustrated in FIG. 7. For example, the memory hub 71 can be referred to as a Northbridge in some architectures, while the I/O hub 51 can be referred to as a Southbridge.

Additional examples are now described. Example 1 is an integrated circuit comprising: configurable logic circuit blocks that are configurable with a first configuration bitstream according to a coarse grained configuration, wherein the coarse grained configuration implements an aggregate circuit structure of the configurable logic circuit blocks, wherein the configurable logic circuit blocks are configurable with a second configuration bitstream according to a fine grained configuration, wherein a total number of bits in the first and the second configuration bitstreams comprises fewer bits than a single fine grained configuration bitstream.

In Example 2, the integrated circuit of Example 1 may optionally include, wherein the configurable logic circuit blocks are configurable to implement fine grained functionality with the second configuration bitstream, and wherein the configurable logic circuit blocks are configurable to implement coarse grained functionality with the first configuration bitstream.

In Example 3, the integrated circuit of any one of Examples 1-2 may optionally include, wherein the first configuration bitstream is used to provide an initial configuration of the integrated circuit, a reconfiguration of the integrated circuit, or a partial reconfiguration of the configurable logic circuit blocks.

In Example 4, the integrated circuit of any one of Examples 1-3 may optionally include, wherein a first one of the configurable logic circuit blocks comprises a first partition that is configurable by the first configuration bitstream to provide first coarse grained functionality, and wherein a second one of the configurable logic circuit blocks comprises a second partition that is configurable by a fourth configuration bitstream to provide second coarse grained functionality in the coarse grained configuration.

In Example 5, the integrated circuit of any one of Examples 1-4 further comprises: a state machine that causes a memory circuit to transfer the second configuration bitstream through a configuration network to the configurable logic circuit blocks in response to receiving the first configuration bitstream.

In Example 6, the integrated circuit of any one of Examples 1-5 may optionally include, wherein the integrated circuit decodes encoded patterns in the first configuration bitstream to generate decoded configuration bits that are used to configure the configurable logic circuit blocks to implement a circuit design for the integrated circuit.

In Example 7, the integrated circuit of any one of Examples 1-6 may optionally include, wherein the configurable logic circuit blocks comprise at least two different types of the configurable logic circuit blocks.

In Example 8, the integrated circuit of any one of Examples 1-7 may optionally include, wherein the integrated circuit comprises a fanout network that is coupled to provide the first configuration bitstream to each of the configurable logic circuit blocks.

Example 9 is a method for reducing a configuration time of configurable logic circuits in an integrated circuit, the method comprising: providing coarse grained functionality for an aggregate configuration of the configurable logic circuits by configuring the configurable logic circuits based on first configuration bits; and providing fine grained functionality for the configurable logic circuits by configuring the configurable logic circuits based on second configuration bits, wherein a total number of the first and the second configuration bits is fewer than a single fine grained configuration bitstream.

In Example 10, the method of Example 9 may optionally include, wherein providing the coarse grained functionality for the aggregate configuration of the configurable logic circuits further comprises changing the coarse grained functionality for the aggregate configuration of the configurable logic circuits using the first configuration bits after the configurable logic circuits have been configured with third configuration bits.

In Example 11, the method of any one of Examples 9-10 further comprises: generating the first configuration bits to represent design patterns for a user design for the integrated circuit based on an inference from the user design.

In Example 12, the method of any one of Examples 9-11 may optionally include, wherein providing the coarse grained functionality for the aggregate configuration of the configurable logic circuits further comprises configuring a first partition of a first configurable logic block using the first configuration bits to provide a first coarse grained configuration, and configuring a second partition of a second configurable logic block using third configuration bits to provide a second coarse grained configuration.

In Example 13, the method of any one of Examples 9-12 may further comprise decoding or decompressing the first configuration bits to generate the second configuration bits.

In Example 14, the method of any one of Examples 9-13 may further comprise accessing the second configuration bits from a memory circuit using a state machine and transferring the second configuration bits from the memory circuit through a configuration network to the configurable logic circuits in response to receiving the first configuration bits.

In Example 15, the method of any one of Examples 9-14 further comprises: configuring the configurable logic circuits to provide intermediate scale functionality using third configuration bits in response to receiving the first configuration bits in the integrated circuit.

Example 16 is a non-transitory computer readable storage medium comprising instructions stored thereon that, when executed by an integrated circuit, cause the integrated circuit to: configure configurable logic circuit blocks in the integrated circuit using first configuration bits to provide coarse grained functionality that implements an aggregate circuit structure for the configurable logic circuit blocks; access second configuration bits in response to receiving the first configuration bits; and configure the configurable logic circuit blocks using the second configuration bits to provide fine grained functionality for the configurable logic circuit blocks, wherein a total number of the first and the second configuration bits is fewer than a single fine grained configuration bitstream.

In Example 17, the non-transitory computer readable storage medium of Example 16 may optionally include, wherein the instructions further cause the integrated circuit to: provide an initial configuration of the integrated circuit, a reconfiguration of the integrated circuit, or a partial reconfiguration of the configurable logic circuit blocks using the first configuration bits.

In Example 18, the non-transitory computer readable storage medium of any one of Examples 16-17 may optionally include, wherein the instructions further cause the integrated circuit to: configure a first partition of a first one of the configurable logic circuit blocks using the first configuration bits to provide a first coarse grained configuration; and configure a second partition of a second one of the configurable logic circuit blocks using third configuration bits to provide a second coarse grained configuration.

In Example 19, the non-transitory computer readable storage medium of any one of Examples 16-18 may optionally include, wherein the instructions further cause the integrated circuit to: access the second configuration bits from a memory circuit using a state machine in response to receiving the first configuration bits; and transfer the second configuration bits from the memory circuit to the configurable logic circuit blocks.

In Example 20, the non-transitory computer readable storage medium of any one of Examples 16-19 may optionally include, wherein the instructions further cause the integrated circuit to: decode or decompress the first configuration bits to generate the second configuration bits.

The foregoing description of the exemplary embodiments has been presented for the purpose of illustration. The foregoing description is not intended to be exhaustive or to be limiting to the examples disclosed herein. The foregoing is merely illustrative of the principles of this disclosure and various modifications can be made by those skilled in the art. The foregoing embodiments may be implemented individually or in any combination.

## Claims

1. An integrated circuit comprising:
configurable logic circuit blocks that are configurable with a first configuration bitstream according to a coarse grained configuration, wherein the coarse grained configuration implements an aggregate circuit structure of the configurable logic circuit blocks, wherein the configurable logic circuit blocks are configurable with a second configuration bitstream according to a fine grained configuration, and wherein a total number of bits in the first and the second configuration bitstreams comprises fewer bits than a single fine grained configuration bitstream.

2. The integrated circuit of claim 1, wherein the configurable logic circuit blocks are configurable to implement fine grained functionality with the second configuration bitstream, and wherein the configurable logic circuit blocks are configurable to implement coarse grained functionality with the first configuration bitstream.

3. The integrated circuit of any one of claims 1-2, wherein the first configuration bitstream is used to provide an initial configuration of the integrated circuit, a reconfiguration of the integrated circuit, or a partial reconfiguration of the configurable logic circuit blocks.

4. The integrated circuit of any one of claims 1-3, wherein a first one of the configurable logic circuit blocks comprises a first partition that is configurable by the first configuration bitstream to provide first coarse grained functionality, and wherein a second one of the configurable logic circuit blocks comprises a second partition that is configurable by a fourth configuration bitstream to provide second coarse grained functionality in the coarse grained configuration.

5. The integrated circuit of any one of claims 1-4 further comprising:
a state machine that causes a memory circuit to transfer the second configuration bitstream through a configuration network to the configurable logic circuit blocks in response to receiving the first configuration bitstream.

6. The integrated circuit of any one of claims 1-5, wherein the integrated circuit decodes encoded patterns in the first configuration bitstream to generate decoded configuration bits that are used to configure the configurable logic circuit blocks to implement a circuit design for the integrated circuit.

7. The integrated circuit of any one of claims 1-6, wherein the configurable logic circuit blocks comprise at least two different types of the configurable logic circuit blocks.

8. The integrated circuit of any one of claims 1-7, wherein the integrated circuit comprises a fanout network that is coupled to provide the first configuration bitstream to each of the configurable logic circuit blocks.

9. A method for reducing a configuration time of configurable logic circuits in an integrated circuit, the method comprising:
providing coarse grained functionality for an aggregate configuration of the configurable logic circuits by configuring the configurable logic circuits based on first configuration bits; and
providing fine grained functionality of the configurable logic circuits by configuring the configurable logic circuits based on second configuration bits, wherein a total number of the first and the second configuration bits is fewer than a single fine grained configuration bitstream.

10. The method of claim 9, wherein providing the coarse grained functionality for the aggregate configuration of the configurable logic circuits further comprises changing the coarse grained functionality for the aggregate configuration of the configurable logic circuits using the first configuration bits after the configurable logic circuits have been configured with third configuration bits.

11. The method of any one of claims 9-10 further comprising:
generating the first configuration bits to represent design patterns for a user design for the integrated circuit based on an inference from the user design.

12. The method of any one of claims 9-11, wherein providing the coarse grained functionality for the aggregate configuration of the configurable logic circuits further comprises configuring a first partition of a first configurable logic block using the first configuration bits to provide a first coarse grained configuration, and configuring a second partition of a second configurable logic block using third configuration bits to provide a second coarse grained configuration.

13. The method of any one of claims 9-12 further comprising decoding or decompressing the first configuration bits to generate the second configuration bits.

14. The method of any one of claims 9-13 further comprising accessing the second configuration bits from a memory circuit using a state machine and transferring the second configuration bits from the memory circuit through a configuration network to the configurable logic circuits in response to receiving the first configuration bits.

15. The method of any one of claims 9-14 further comprises:
configuring the configurable logic circuits to provide intermediate scale functionality using third configuration bits in response to receiving the first configuration bits in the integrated circuit.
